# FASCICULE DE BREVET EUROPEEN

(11) **EP 1 905 734 B1**
(45) Date de publication et mention de la délivrance du brevet: **06.05.2009**
(21) Numéro de dépôt: 07117116.9
(22) Date de dépôt: 25.09.2007
(51) Int. Cl.: B81C 1/00, H03H 3/007, H03H 9/24

(54) **Procédé de réalisation d'un composant éléctromécanique sur un substrat plan**
Herstellungsverfahren für ein elektromechanisches Bauteil auf einem ebenen Substrat
Method of manufacture of an electromechanical component on a planar substrate

(30) Priorité: 27.09.2006 FR 0653975
(43) Date de publication de la demande: 02.04.2008
(73) Titulaire: COMMISSARIAT A L'ENERGIE ATOMIQUE, 75015 Paris (FR); STMicroelectronics SA, 92120 Montrouge (FR)
(72) Inventeur: Casset, Fabrice, 38570, TENCIN (FR); Durand, Cédric, 38400, SAINT MARTIN D'HERES (FR); Ancey, Pascal, 38420, REVEL (FR)
(74) Mandataire: Ilgart, Jean-Christophe

(56) Documents cités:
- DE-A1- 10 226 027
- FR-A- 2 881 416
- FR-A1- 2 857 952
- FR-A1- 2 872 501
- MALGORZATA JURCZAK ET AL: "Silicon-on-Nothing (SON)-an Innovative Process for Advanced CMOS" IEEE TRANSACTIONS ON ELECTRON DEVICES, IEEE SERVICE CENTER, PISACATAWAY, NJ, US, vol. 47, no. 11, novembre 2000 (2000-11), XP011017406 ISSN: 0018-9383

## Description

### DOMAINE TECHNIQUE ET ART ANTÉRIEUR

L'invention concerne un procédé de réalisation d'un composant électromécanique sur un substrat plan et comportant au moins une structure vibrante dans le plan du substrat et des électrodes d'actionnement.

L'invention s'applique plus particulièrement à la fabrication de microsystèmes électromécaniques (MEMS) ou de nanosystèmes électromécaniques (NEMS), comportant une structure vibrante avec déplacement dans le plan du substrat.

Le développement d'appareils portables de plus en plus petits et performants pousse à rechercher des nouveaux composants permettant de réaliser de nouvelles fonctionnalités. Dans les applications radiofréquences, notamment du type téléphonie mobile, PC portable, objets communicants, etc..., les micro ou nano systèmes électromécaniques (MEMS ou NEMS) sont des alternatives crédibles aux composants « classiques » de la microélectronique de par leur intégration et leurs performances théoriques.

Pour la réalisation de tels MEMS/NEMS, la technologie SON (« Silicon on Nothing ») peut être utilisée. La technologie SON consiste globalement en l'épitaxie d'une couche sacrificielle en alliage de silicium et de germanium SiGe (avec 30% de germanium par exemple) de quelques nanomètres (typiquement 20nm à 50nm), puis en l'épitaxie de silicium, qui aura la caractéristique d'être monocristallin au-dessus de la couche en silicium et germanium. Ensuite, la couche en silicium et germanium est gravée sélectivement par rapport au silicium. Cette opération permet d'obtenir des zones localisées de silicium suspendu (« On Nothing »), bien adaptées à la réalisation de MEMS/NEMS.

Le grand avantage de la technologie SON, notamment par rapport à la technologie classique du silicium sur isolant SOI (« Silicon on Insulator »), est la possibilité de travailler localement sur une plaquette standard, plus communément appelée par le terme anglo-saxon « wafer », avec une zone active ou suspendue locale. Il en résulte un gain important en termes de coût, les plaquettes en silicium sur isolant SOI étant beaucoup plus chères, comparé au coût des plaquettes utilisées en technologie SON.

Généralement, les procédés de fabrication des MEMS/NEMS englobent la réalisation de circuits électroniques et de transistors. Les MEMS/NEMS peuvent ainsi être réalisés après les circuits et les transistors (réalisation « above IC ») ou bien en même temps. Dans le premier cas, le procédé de réalisation des MEMS/NEMS a pour contrainte de ne pas endommager les circuits. Il s'agit d'un procédé « above IC », limité en termes de matériaux, notamment pas d'or ni de cuivre, et de température, notamment inférieure à 350°C, ce qui limite le plus souvent la qualité des matériaux utilisés. À titre d'exemple, l'oxyde de silicium SiO₂, le nitrure de silicium SiN, l'alliage de silicium et germanium SiGe sont moins bons lorsque la température de dépôt est basse. Il en résulte notamment l'impossibilité d'obtenir du silicium monocristallin.

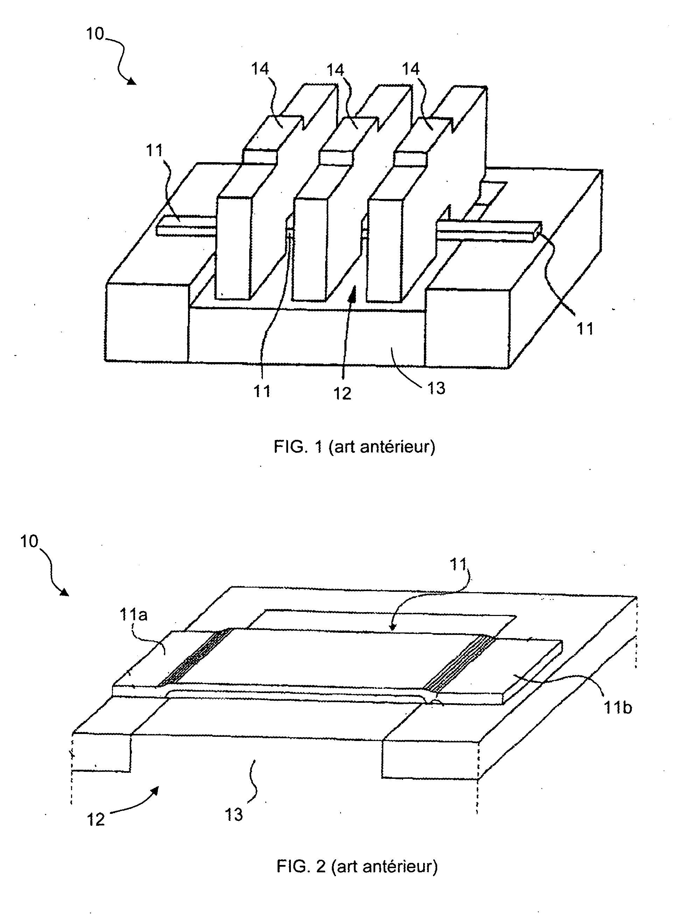

Dans le second cas, le procédé de réalisation de MEMS/NEMS doit être compatible avec le procédé de réalisation des transistors. À titre d'exemple, le document US 2005/0199970 décrit notamment la réalisation d'un composant électromécanique, de type résonateur à poutre vibrante, par la technologie SON. Comme représenté sur la figure 1, le résonateur 10 comporte une poutre vibrante 11 vibrant « hors plan », c'est-à-dire selon une direction perpendiculaire à un substrat plan 12, sur lequel est réalisée la poutre 11. Dans ce cas, le substrat 12 comporte une zone active 13, en silicium fortement dopé, destinée à servir d'électrode d'actionnement pour la poutre 11 et coopérant avec des électrodes 14 de détection et d'actionnement, réalisées après la poutre vibrante 11, au-dessus de celle-ci. Sur la figure 1, la poutre vibrante 11 est, par exemple, en silicium monocristallin, et le résonateur 10 comporte trois électrodes 14, sensiblement en forme de pont, chevauchant la poutre 11 au-dessus de la zone active 13 du substrat 12.

Un autre exemple de réalisation d'un procédé de fabrication d'un MEMS/NEMS utilisant la technologie SON est décrit dans le document FR 2 823 032. Comme représenté sur la figure 2, le procédé consiste à former un résonateur 10 du type poutre vibrante 11 « hors plan », réalisée au-dessus d'un substrat 12 comportant une zone active 13, jouant le rôle d'électrode d'actionnement. Cependant, le procédé décrit dans le document ci-dessus est extrêmement réducteur, dans la mesure où il ne considère qu'un résonateur de type poutre vibrante 11, ancrée à ses deux extrémités 11a, 11b et limité en termes de performances, car sollicitée uniquement en flexion. De plus, la poutre vibrante 11 présente une vibration « hors plan » (déplacement perpendiculaire au substrat) impliquant la réalisation des électrodes de détection et d'actionnement selon des étapes supplémentaires à la réalisation de la poutre vibrante 11. Il en résulte un coût d'étapes technologiques supplémentaires.

Pour la réalisation d'électrodes capacitives, il est également classique de réaliser des composants vibrant « hors plan » et nécessitant lors de la réalisation trois étapes distinctes, à savoir la réalisation de l'électrode fixe (sur le substrat le plus souvent), la réalisation d'une couche sacrificielle et la réalisation d'une électrode mobile (composant mobile).

Il existe néanmoins des capacités variables fonctionnant « dans le plan » (déplacement parallèle au substrat) permettant de simplifier la réalisation en ne nécessitant que deux étapes, à savoir la réalisation de la couche sacrificielle et la réalisation en même temps de l'électrode fixe et de l'électrode mobile. C'est le cas, par exemple, de la capacité variable par variation de surface développée par Yao, Park et DeNatale dans l'article « High tuning ratio MEMS based tunable capacitors for RF communications applications » (Tech. Digest, Solid State Sensor and Actuator Workshop, pp 124-7, 1998). La structure est constituée d'une ligne de peignes interdigités fixes, et une autre ligne de peignes interdigités mobiles. L'application d'une force électrostatique va provoquer le déplacement latéral de la partie mobile et le mouvement à pour effet de faire varier les surfaces en regard des peignes et donc la capacité.

Cependant, une telle structure est classiquement réalisée à partir d'un substrat en silicium sur isolant SOI (Silicon on Insulator), qui permet d'obtenir un composant en silicium monocristallin. Or, les substrats SOI présentent le grand désavantage d'être très onéreux. De plus, les capacités variables sont le plus souvent réalisées en technologies froides ou « above IC » (température limité à 400°C) induisant des matériaux constitutifs de mauvaise qualité d'un point de vue mécanique (métaux comme l'or, l'AlSi,...) et stockant des charges pouvant parasiter leur comportement (nitrure, oxyde basse température, etc...).

Le document DE 10226027 A1 décrit également la réalisation d'un composant micromécanique comportant des électrodes vibrantes dans le plan du substrat. Les électrodes vibrantes sont formés au-dessus d'une couche sacrificielle en oxyde. Ainsi, le matériau des électrodes est polycristallin.

### EXPOSÉ DE L'INVENTION

L'invention a pour but de remédier aux inconvénients précités et a pour objet un procédé de réalisation d'un composant électromécanique, plus particulièrement du type MEMS/NEMS, qui soit simple à réaliser, peu coûteux et qui permette notamment la réalisation d'un composant électromécanique avec une performance optimale en termes de caractéristiques de fonctionnement.

L'objet de l'invention est caractérisé en ce que le procédé comporte au moins les étapes successives suivantes :
- formation du substrat comportant au moins une zone en silicium munie d'une surface supérieure recouverte en partie par au moins une zone isolante,
- formation d'une couche sacrificielle en alliage de silicium et de germanium par épitaxie sélective à partir de la partie non recouverte de la surface supérieure de la zone en silicium,
- formation par épitaxie d'une couche en silicium, d'épaisseur prédéterminée, comportant au moins une zone monocristalline disposée sur ladite couche sacrificielle et au moins une zone polycristalline disposée sur ladite zone isolante,
- formation simultanée de la structure vibrante et des électrodes d'actionnement, par gravure dans la zone monocristalline d'un motif prédéterminé destiné à former des espaces entre les électrodes et la structure vibrante,
- élimination par gravure sélective de ladite couche sacrificielle en alliage de silicium et de germanium.

Selon un développement de l'invention, la couche en silicium est fortement dopée.

Selon un autre développement de l'invention, l'épaisseur de la structure vibrante et des électrodes du composant électromécanique est de l'ordre de 100nm à 600nm.

Selon un mode particulier de réalisation de l'invention, le procédé comporte une étape de fabrication d'un capot d'encapsulation de la structure vibrante du composant électromécanique.

Ladite étape de fabrication du capot d'encapsulation peut comporter, après la formation simultanée de la structure vibrante et des électrodes par gravure, les étapes suivantes :
- formation par épitaxie et gravure d'une deuxième couche sacrificielle en alliage de silicium et de germanium,
- formation par épitaxie d'une couche en silicium monocristallin, destinée à former le capot d'encapsulation,
- formation par gravure d'une pluralité d'orifices dans le capot,
- élimination par gravure sélective à travers lesdits orifices des première et deuxième couches sacrificielles en alliage de silicium et de germanium,
- formation sur le capot d'une couche en matériau de rebouchage.

Le procédé peut comporter, avant la formation simultanée de la structure vibrante et des électrodes, la formation d'une couche additionnelle en silicium non dopé, par épitaxie à partir de la première couche en silicium.

Le procédé peut comporter la formation d'un transistor semi-conducteur en métal/oxyde, simultanément à la formation de la structure vibrante et des électrodes.

Le procédé peut comporter la formation de capacités variables simultanément à la formation de la structure vibrante et des électrodes.

### BRÈVE DESCRIPTION DES DESSINS

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent chacune un composant électromécanique réalisé par la technologie SON selon l'art antérieur.
Les figures 3 à 7 sont des vues de face en coupe, représentant différentes étapes successives d'un procédé de réalisation d'un composant électromécanique selon l'invention.
La figure 8 est une vue de face en coupe illustrant une variante de réalisation d'un procédé de réalisation d'un composant électromécanique selon l'invention, simultanément à la réalisation d'un transistor.
La figure 9 est une vue de dessus très schématique d'une variante de réalisation d'un procédé de réalisation d'un composant électromécanique selon l'invention.
Les figures 10 à 12 sont des vues de face très schématiques illustrant une variante de réalisation d'un procédé de réalisation d'un composant électromécanique selon l'invention, équipé d'un capot d'encapsulation.

### EXPOSÉ DÉTAILLÉ DE MODES DE RÉALISATION PARTICULIERS

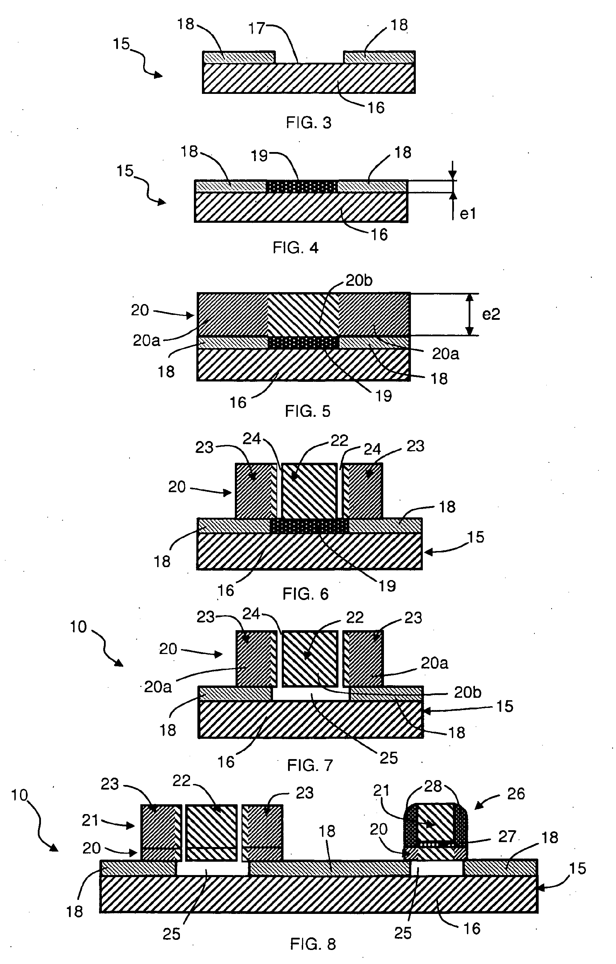

En référence aux figures 3 à 12, le procédé de réalisation selon l'invention d'un composant électromécanique 10 est destiné plus particulièrement à la fabrication de composants MEMS ou NEMS du type résonateur (figure 7), comportant une structure vibrante et des électrodes d'actionnement, destinées à entraîner le déplacement de la structure vibrante dans le plan du substrat sur lequel est réalisé le composant, à savoir parallèlement au substrat.

Le procédé selon l'invention consiste à réaliser les électrodes d'actionnement simultanément à la structure vibrante du composant, afin que les électrodes et la structure vibrante soient dans un même plan parallèle au substrat. La structure vibrante peut alors se déplacer dans le plan du substrat et peut prendre tout type de forme, pas uniquement une poutre sollicitée en flexion, ce qui permet notamment d'optimiser ses performances.

Un mode particulier de réalisation d'un composant MEMS/NEMS 10, du type résonateur, va être décrit plus en détails au regard des figures 3 à 7. Sur la figure 3, la première étape du procédé consiste à former un substrat plan 15 comportant, par exemple, une zone en silicium 16, de préférence non conductrice, avec une surface supérieure 17 recouverte partiellement, par exemple, par deux zones isolantes 18, par exemple en oxyde thermique. Les zones isolantes 18 sont réalisées, par exemple, par dépôt par lithographie d'une couche d'oxyde, puis gravure de la couche d'oxyde selon la forme souhaitée des zones isolantes 18.

À titre d'exemple, dans le cas où le substrat 15 est de section rectangulaire, les zones isolantes 18 sont gravées sous forme de tranches disposées sur la zone en silicium 16. Dans le cas où le substrat 15 est de forme circulaire, le substrat 15 comporte alors une seule zone isolante 18 recouvrant une partie de la périphérie de la zone en silicium 16.

Sur la figure 4, une couche sacrificielle 19 en alliage de silicium et de germanium est ensuite formée, par exemple, par épitaxie sélective, c'est-à-dire que la couche sacrificielle 19 croit à partir de la partie non recouverte par les zones isolantes 18 de la zone en silicium 16. L'épaisseur e1 de la couche sacrificielle 19 en alliage de silicium et de germanium est, de préférence, de l'ordre de quelques nanomètres, par exemple de 20nm à 50nm.

Sur la figure 5, une couche 20 en silicium, de préférence, très fortement dopé est ensuite formée par épitaxie. La couche 20 a une épaisseur prédéterminée e2, de préférence de l'ordre de 100nm à 600nm, et croit par épitaxie à partir des zones isolantes 18 et de la couche sacrificielle 19. La vitesse de croissance est différente selon les zones de la couche 20 en silicium. Les zones 20a de la couche 20, qui croissent à partir des zones isolantes 18, sont en silicium polycristallin, tandis que la zone 20b de la couche 20, qui croît à partir de la couche sacrificielle 19 en alliage de silicium et de germanium, est en silicium monocristallin.

Sur la figure 5, les zones 20a en silicium polycristallin sont représentées par des hachures inclinées vers le haut et vers la droite et la zone 20b en silicium monocristallin est représentée par des hachures espacées et inclinées vers le haut et vers la gauche. Dans le mode particulier de réalisation représenté sur la figure 5, les zones 20a et 20b sont délimitées sensiblement à la verticale. En réalité, la croissance par épitaxie engendre une interface sensiblement inclinée entre les différentes zones.

Sur la figure 6, le procédé comporte ensuite la formation simultanée de la structure vibrante 22 du composant 10 MEMS/NEMS et aussi des électrodes d'actionnement 23, destinées à faire vibrer la structure vibrante 22 dans le plan parallèlement au substrat 15. La formation se fait par gravure de la couche 20 en silicium, de préférence uniquement au niveau de la zone monocristalline 20b. L'étape de gravure consiste à graver la couche en silicium 20, selon un motif prédéterminé destiné à former des espaces 24 entre la structure vibrante 22 et les électrodes 23. L'étape de gravure des électrodes 23, simultanément à la gravure de la structure vibrante 22 permet notamment de positionner les électrodes 23 et la structure vibrante 22 dans un même plan, parallèle au substrat 15. Les électrodes 23 sont formées sur les zones isolantes 18, sont isolées électriquement du reste du substrat 15 et sont disposées, de préférence, de part et d'autre de la structure vibrante 22, laquelle vibre ainsi dans le plan du substrat 15.

Par ailleurs, comme représenté sur la figure 6, les espaces 24 de gravure sont réalisés dans la zone monocristalline 20b de la couche 20 en silicium, légèrement à l'écart des zones isolantes 18, notamment pour éviter tout problème d'alignement entre les masques de lithographie utilisés par exemple lors du dépôt des différentes couches. De plus, les espaces 24 sont réalisés dans la zone monocristalline 20b, de sorte que la structure vibrante 22 est uniquement en silicium monocristallin et les électrodes 23 présentent une première partie en silicium polycristallin, au-dessus des zones isolantes 18, et une autre partie en silicium monocristallin, au-dessus de la couche sacrificielle 19, juste en regard de la structure vibrante 22. Ainsi, la structure vibrante 22 est réalisée loin de la zone de jonction entre le silicium monocristallin et le silicium polycristallin de la couche 20, laquelle zone de jonction est riche en dislocations et donc moins bonne d'un point de vue performances mécaniques.

Un tel procédé de réalisation, avec gravure simultanée de la structure vibrante 22 et des électrodes 23, permet notamment de réaliser tout type de forme pour la structure vibrante 22. Par ailleurs, l'épaisseur de la structure vibrante 22 et des électrodes 23, de préférence de l'ordre de 100nm à 600nm, est relativement importante comparée à l'épaisseur des poutres selon l'art antérieur, afin d'obtenir de meilleures performances en termes notamment de qualité de vibration.

À titre d'exemple, la structure vibrante 22 peut être une poutre longitudinale, ancrée au niveau de la partie centrale de ses bords longitudinaux. Dans ce cas, la poutre peut être polarisée par une tension amenée par ces points d'ancrage et le signal radiofréquence apporté à une électrode située à une de ses extrémités va faire vibrer la poutre dans un mode de résonance longitudinal, à savoir une extension de la poutre selon sa longueur.

La structure vibrante 22 peut également avoir la forme d'un disque, ancré sur son contour selon quatre points d'ancrage disposés régulièrement à 90° les uns par rapport aux autres, ou ancré en son centre selon un point d'ancrage central, pour former une structure du type champignon. Le principe de fonctionnement est le même que précédemment et le mode de vibration de la structure vibrante 22 est alors elliptique.

La structure vibrante 22 peut également être une plaque vibrante ancrée à ses quatre coins. La plaque se déforme alors en compression-extension, à savoir deux bords opposés parallèles se rapprochant l'un vers l'autre, tandis que les deux autres bords s'éloignant l'un de l'autre dans un premier mode de vibration et inversement dans un second mode de vibration.

Sur la figure 7, l'étape suivante du procédé de réalisation du composant 10 consiste à éliminer la couche sacrificielle 19 en alliage de silicium et de germanium par gravure sélective, notamment par rapport au silicium monocristallin de la structure vibrante 22, afin de former un espace 25 au-dessus de la zone en silicium 16. Les électrodes 23 sont alors légèrement suspendues au-dessus du substrat 15 par leurs parties en silicium monocristallin (hachures orientées vers le haut et vers la gauche) et la structure vibrante 22 est libérée du substrat 15 et peut vibrer dans le plan, entre les électrodes d'actionnement 23.

Le composant électronique 10 de type MEMS/NEMS ainsi obtenu par la technologie SON (« Silicon On Nothing » en anglais, ou « silicium sur rien »), qui permet donc de suspendre une structure vibrante 22 pouvant prendre tout type de forme, présente ainsi une amélioration de ses performances, ainsi qu'un gain en termes de coût de fabrication.

Dans la variante de réalisation représentée sur la figure 8, le procédé selon l'invention comporte la réalisation d'un transistor 26 semi-conducteur en métal/oxyde (MOS), en même temps que la réalisation de la structure vibrante 22 et des électrodes 23 du composant MEMS/NEMS 10 décrit précédemment. La réalisation du transistor 26 s'effectue comme précédemment par la technologie SON de manière classique.

Sur la figure 8, le procédé comporte, de préférence, le dépôt d'une couche additionnelle 21 en silicium, de préférence non dopé, d'épaisseur prédéterminée, après l'étape de formation de la couche en 20 en silicium fortement dopé. L'épaisseur des deux couches 20, 21 est alors, de préférence, de l'ordre de 100nm à 600nm. Comme précédemment, la couche 21 comporte deux zones en silicium polycristallin 21a, qui croissent à partir des zones en silicium polycristallin de la couche 20, et une zone 21b en silicium monocristallin, qui croit à partir de la zone 20a en silicium monocristallin de la couche 20.

Le transistor 26 comporte alors la première couche 20 en silicium dopé, formant la base du transistor au-dessus de la zone en silicium 16 correspondante du substrat 15, une couche d'oxyde 27, déposée sur la couche 20 et gravée avant la formation et la gravure de la couche additionnelle 21 en silicium, comme décrit précédemment.

Après la gravure de la couche additionnelle 21 en silicium, et avant l'élimination de la couche sacrificielle 19 en alliage de silicium et de germanium, destinée à former la cavité 25 après élimination, le procédé comporte la réalisation d'espaceurs 28, par exemple en nitrure, réalisés, par exemple, par dépôt d'oxyde. Les espaceurs 28 sont destinés notamment à protéger le transistor 26, lors de la gravure sélective de la couche sacrificielle 19 en alliage de silicium et de germanium correspondante, destinée à libérer le transistor 26 du substrat 15.

Dans le mode particulier de réalisation de la figure 8, la zone en silicium 16 est très faiblement dopée. La couche d'oxyde 27 est réalisée par une étape de lithographie permettant de définir une protection pour le canal du transistor 26, avant d'implanter fortement le reste du silicium des couches 20, 21, pour réaliser la source et le drain (couche 20 en silicium) et la grille (couche 21 en silicium) du transistor 26. Par ailleurs, le procédé comporte classiquement des étapes de remplissage du tunnel par un matériau isolant et de nombreuses étapes d'implantation et de prises de contact. Un tel procédé selon l'invention permet donc de réaliser à la fois un composant MEMS/NEMS 10 et un transistor 26 sur un même substrat 15 plan.

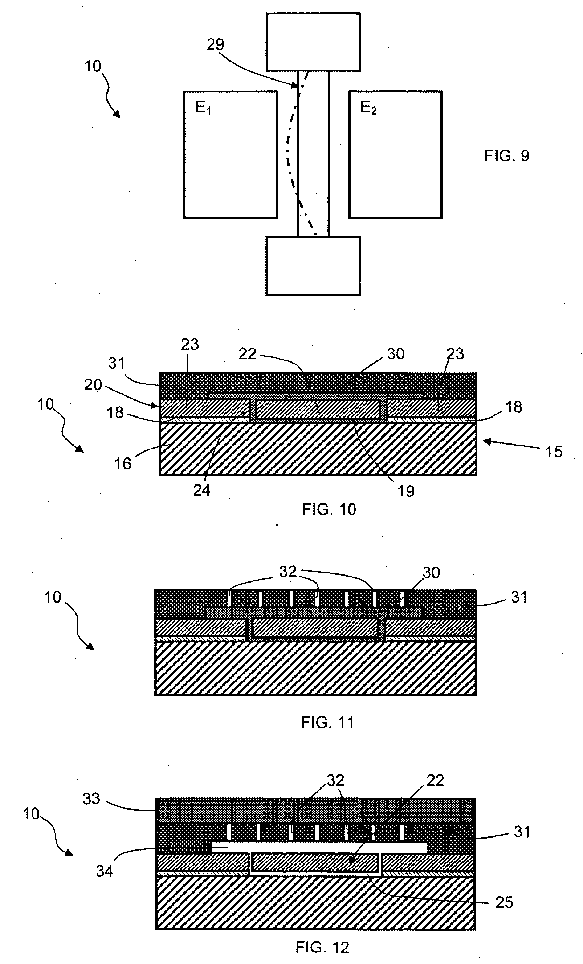

Dans la variante de réalisation représentée sur la figure 9, le procédé de réalisation consiste à former des capacités variables MEMS ou NEMS en silicium monocristallin (représentées très schématiquement sur la figure 9). Il est ainsi possible de réaliser sur un même substrat de support 15 plan un composant MEMS/NEMS 10 comportant à la fois un résonateur avec une structure vibrante et des électrodes d'actionnement, comme décrit précédemment, et aussi des capacités variables, dans le but de réaliser des fonctions intégrées.

Comme représenté schématiquement sur la figure 9, illustrant une capacité variable en vue de dessus, la structure formée par gravure de la couche 20 en silicium, et éventuellement de la couche 21 en silicium, a la forme, par exemple, d'une poutre encastrée 29, présentant différents états de capacité en fonction de la tension appliquée. À titre d'exemple, une tension U1 appliquée entre l'électrode E1 et la poutre 29 va induire un déplacement vers cette électrode E1, représenté schématiquement par la courbe en traits pointillés orientée vers la gauche sur la figure 9, sans aller jusqu'à l'instabilité électrostatique appelé « pull-in » impliquant le collage des deux électrodes E1 et E2. La capacité entre la deuxième électrode E2 et la poutre 29 sera alors minimale.

En abaissant progressivement la tension U1, la poutre 29 va revenir progressivement dans sa position d'origine, et la valeur de capacité va croître. De la même manière, en augmentant régulièrement la tension U2 entre l'électrode E2 et la poutre 29, celle-ci va se déplacer vers l'électrode E2, à savoir vers la droite sur la figure 9, afin de faire varier la capacité.

Le procédé selon l'invention permet ainsi d'obtenir une poutre 29 et des électrodes E1 et E2 d'épaisseur relativement importante, résultant de la gravure des couches 20, et éventuellement 21, en silicium, pouvant aller jusqu'à 600nm. Il en résulte un gain important en termes de performances capacitives, car les surfaces en regard des électrodes E1, E2 se déplaçant les unes par rapport aux autres sont ainsi relativement grandes.

Dans la variante de réalisation représentée sur les figures 10 à 12, le procédé de réalisation du composant électromécanique 10 comporte des étapes supplémentaires destinées à la fabrication d'un capot d'encapsulation de la structure vibrante 22 du composant 10, notamment pour la protection de la structure vibrante 22 mobile en fonctionnement et afin d'assurer sa fiabilité, à savoir une encapsulation sous vide ou sous atmosphère neutre, comme l'argon ou l'hélium.

Dans le mode particulier de réalisation de la figure 10, le composant 10 est formé comme précédemment par la technologie SON, avec le substrat 15 constitué essentiellement par la zone en silicium 16 et les zones isolantes 18 disposées en partie sur la surface supérieure 17 de la zone en silicium 16. Après gravure du silicium de la couche 20, et éventuellement de la couche additionnelle 21 (figure 8), pour former la structure vibrante 22 et les électrodes 23, et, de préférence, avant l'élimination par gravure de la couche sacrificielle 19 en alliage de silicium et de germanium, une nouvelle couche sacrificielle 30 en alliage de silicium et de germanium est formée, par exemple, par épitaxie sur les électrodes 23 et la structure vibrante 22. La couche 30 est, de préférence, assez épaisse, de l'ordre de 50nm à 150nm.

Dans le mode particulier de réalisation représenté sur la figure 10, le matériau de la couche 30 bouche les espaces 24 entre les électrodes 23 et la structure vibrante 22 et la couche 30 est gravée selon la taille souhaitée de la cavité 34, destinée à être formée au-dessus de la structure vibrante 22 (figure 12). Puis, un capot 31 est formé, par exemple, par épitaxie de silicium monocristallin au-dessus des zones monocristallines réalisées au préalable (couche 30 en alliage de silicium et de germanium) et par épitaxie de silicium polycristallin au-dessus des zones polycristallines (électrodes 23 et zones isolantes 18) réalisées au préalable.

Sur la figure 11, des orifices 32 sont ensuite formés dans le capot 31, de préférence des orifices débouchant jusqu'à la couche sacrificielle 30 en alliage de silicium et de germanium. Puis, comme représenté sur la figure 12, les couches sacrificielles 19 et 30 en alliage de silicium et de germanium sont éliminées par gravure sélective, à travers les orifices 32 du capot 31, pour libérer la structure vibrante 22 et former la cavité 25 au-dessous de la structure vibrante 22 et une cavité 34 au-dessus de la structure vibrante 22. Enfin, une couche 33 en matériau de rebouchage permet de boucher les orifices 32 du capot 31, au-dessus de la structure vibrante 22, afin de finaliser l'encapsulation. Le matériau de rebouchage est, de préférence, un matériau « non conformé », c'est-à-dire apte à boucher les orifices 32 sans pénétrer dans la cavité 34 formée au préalable, par exemple une couche en oxyde, en silicium polycristallin ou en nitrure de silicium.

Un tel procédé de réalisation présente l'avantage d'être simplifié, dans la mesure où une unique étape d'élimination par gravure des couches sacrificielles 19 et 30 en alliage de silicium et de germanium est nécessaire. Par ailleurs, les étapes permettant de réaliser l'encapsulation sont basées sur le même principe que pour la réalisation de la structure vibrante 22 et des électrodes 23, à savoir la technologie SON. Il en résulte un gain important en termes de coût et de temps de fabrication.

Quel que soit le mode de réalisation décrit ci-dessus, un tel procédé de réalisation d'un composant électromécanique 10 selon l'invention permet donc de combiner à la fois un résonateur, avec une structure vibrante et des électrodes, un transistor et des capacités variables sur un même substrat, par les mêmes étapes de dépôt de couches et de gravure. Pour la réalisation de la structure vibrante 22, il est possible de réaliser tout type de forme entraînant une vibration dans le plan, afin d'optimiser ses performances, notamment en termes de fréquence de résonance et de facteur de qualité élevés. Par ailleurs, il est possible de réaliser une encapsulation sélective pour chaque structure vibrante 22 indifféremment.

L'invention n'est pas limitée aux différents modes de réalisation décrits ci-dessus. La structure vibrante 22 du composant MEMS/NEMS 10 obtenu par le procédé de réalisation selon l'invention peut être notamment de forme annulaire. Par ailleurs, le composant MEMS/NEMS 10 peut être un accéléromètre. Dans ce cas, des masses sismiques sont insérées en diminuant la rigidité de l'ancrage. Il est également possible de réaliser des résonateurs couplés par le procédé selon l'invention.

Le procédé de réalisation selon les figures 3 à 7 peut comporter également une étape de dépôt d'une couche additionnelle 21 en silicium, tant que l'épaisseur des deux couches 20, 21 en silicium est de l'ordre de 100nm à 600nm.

Dans une variante de réalisation non représentée, le substrat 15, comme représenté sur la figure 3, peut être réalisé différemment et peut comporter une zone en silicium 16 au même niveau que les zones isolantes 18. La première étape de formation du substrat 15 du procédé selon l'invention comporte alors la gravure de la zone 16 en silicium, le dépôt des zones isolantes 18 dans les rainures correspondant à la gravure réalisée au préalable et une étape de planarisation du substrat 15 ainsi obtenu. Les zones isolantes 18 sont alors intégrées dans le substrat 15 et la surface supérieure de la zone en silicium 16 non recouverte du substrat 15 est alors au même niveau que la surface supérieure des zones isolantes 18.

Les étapes suivantes du procédé s'effectuent alors comme précédemment avec la formation de la couche sacrificielle 19 en alliage de silicium et de germanium, qui fait alors légèrement saillie au-dessus du substrat 15 (de l'ordre de quelques nanomètres ou dizaines de nanomètres), et la formation de la couche 20 en silicium, de préférence, fortement dopé. Après gravure simultanée des électrodes 23 et de la structure vibrante 22, dans la zone monocristalline 20b de la couche 20 en silicium, il subsiste alors une légère différence de hauteur entre la structure vibrante 22 en silicium monocristallin et les parties en silicium polycristallin des électrodes 23. Cette différence de hauteur, typiquement celle de la couche sacrificielle 19, est alors sans incidence sur le fonctionnement et sur les performances du composant 10, dans la mesure où les parties des électrodes 23 en regard de la structure vibrante 22 sont en silicium monocristallin et sont donc à la même hauteur que la structure vibrante 22 (figure 7).

Dans une autre variante de réalisation non représentée du procédé de réalisation selon les figures 10 à 12, le dépôt de la seconde couche sacrificielle 30 en alliage de silicium et de germanium peut être réalisée après la gravure de la structure vibrante 22 et des électrodes 23, c'est-à-dire après la libération de la structure vibrante 22. Le matériau de la couche 30 en alliage de silicium et de germanium bouche alors uniquement les extrémités des espaces 24 entre la structure vibrante 22 et les électrodes 23, lors de son dépôt, et la formation du capot d'encapsulation 31 s'effectue comme décrit précédemment, avec gravure uniquement de la couche 30 en alliage de silicium et de germanium pour libérer le capot 31.

L'invention peut s'appliquer à tout type de composant électromécanique nécessitant la réalisation simultanée d'une structure vibrante, dans le même plan que ses électrodes d'actionnement.

## Revendications

1. Procédé de réalisation d'un composant électromécanique (10) sur un substrat (15) plan et comportant au moins une structure vibrante (22) dans le plan du substrat (15) et des électrodes d'actionnement (23), le procédé comportant au moins les étapes successives suivantes :
- formation du substrat (15) comportant au moins une zone en silicium (16) munie d'une surface supérieure (17) recouverte en partie par au moins une zone isolante (18),
- formation d'une couche sacrificielle (19) en alliage de silicium et de germanium par épitaxie sélective à partir de la partie non recouverte de la surface supérieure (17) de la zone en silicium (16),
- formation par épitaxie d'une couche (20) en silicium, d'épaisseur (e2) prédéterminée, comportant au moins une zone monocristalline (20b) disposée sur ladite couche sacrificielle (19) et au moins une zone polycristalline (20a) disposée sur ladite zone isolante (18),
- formation simultanée de la structure vibrante (22) et des électrodes d'actionnement (23), par gravure dans la zone monocristalline (20b) d'un motif prédéterminé destiné à former des espaces (24) entre les électrodes (23) et la structure vibrante (22),
- élimination par gravure sélective de ladite couche sacrificielle (19) en alliage de silicium et de germanium.

2. Procédé selon la revendication 1, la couche (20) en silicium étant fortement dopée.

3. Procédé selon l'une des revendications 1 et 2, l'épaisseur de la structure vibrante (22) et des électrodes (23) du composant électromécanique (10) étant de l'ordre de 100nm à 600nm.

4. Procédé selon l'une quelconque des revendications 1 à 3, comportant une étape de fabrication d'un capot d'encapsulation (31) de la structure vibrante (22) du composant électromécanique (10).

5. Procédé selon la revendication 4, ladite étape de fabrication du capot d'encapsulation (31) comportant, après la formation simultanée de la structure vibrante (22) et des électrodes (23) par gravure, les étapes suivantes :
- formation par épitaxie et gravure d'une deuxième couche sacrificielle (30) en alliage de silicium et de germanium,
- formation par épitaxie d'une couche en silicium monocristallin, destinée à former le capot d'encapsulation (31),
- formation par gravure d'une pluralité d'orifices (32) dans le capot (31),
- élimination par gravure sélective à travers lesdits orifices (32) des première (19) et deuxième (30) couches sacrificielles en alliage de silicium et de germanium,
- formation sur le capot (31) d'une couche (33) en matériau de rebouchage.

6. Procédé selon l'une quelconque des revendications 1 à 5, comportant, avant la formation simultanée de la structure vibrante (22) et des électrodes (23), la formation d'une couche additionnelle (21) en silicium non dopé, par épitaxie à partir de la première couche (20) en silicium.

7. Procédé selon la revendication 6, comportant la formation d'un transistor (26) semiconducteur en métal/oxyde, simultanément à la formation de la structure vibrante (22) et des électrodes (23).

8. Procédé selon l'une quelconque des revendications 1 à 7, comportant la formation de capacités variables (39, E1, E2) simultanément à la formation de la structure vibrante (22) et des électrodes (23).

## Claims

1. Method for making an electromechanical component (10) on a plane substrate (15) and comprising at least one structure (22) vibrating in the plane of the substrate (15) and actuation electrodes (23), the method comprising at least the following steps in sequence:
- formation of the substrate (15) comprising at least one silicon area (16) provided with an upper surface (17) at least partly covered by one insulating area (18),
- formation of a sacrificial silicon and germanium alloy layer (19) by selective epitaxy starting from the uncovered part of the upper surface (17) of the silicon area (16),
- formation of a silicon layer (20) with a predetermined thickness (e2) by epitaxy, comprising at least one monocrystalline area (20b) arranged on said sacrificial layer (19) and at least one polycrystalline area (20a) arranged on said insulating area (18),
- simultaneous formation of the vibrating structure (22) and actuation electrodes (23), by etching a predetermined pattern in the monocrystalline area (20b) designed to form spaces (24) between the electrodes (23) and the vibrating structure (22),
- elimination of said sacrificial layer (19) made of silicon and germanium alloy, by selective etching.

2. Method according to claim 1, the silicon layer (20) being strongly doped.

3. Method according to one of claims 1 and 2, the thickness of the vibrating structure (22) and the electrodes (23) of the electromechanical component (10) being of the order of 100nm to 600nm.

4. Method according to any one of claims 1 to 3, comprising a step to make an encapsulation cover (31) for the vibrating structure (22) of the electromechanical component (10).

5. Method according to claim 4, said step to make the encapsulation cover (31) comprising the following steps after simultaneous formation of the vibrating structure (22) and electrodes (23) by etching:
- formation of a second sacrificial silicon and germanium alloy layer (30), by epitaxy,
- formation of a monocrystalline silicon layer by epitaxy, intended to form the encapsulation cover (31),
- formation of a plurality of orifices (32) by etching in the cover (31),
- elimination of first (19) and second (30) sacrificial silicon and germanium alloy layers by selective etching through said orifices (32),
- formation of a layer (33) made of a closing off material on the cover (31).

6. Method according to any one of claims 1 to 5, comprising formation of an additional undoped silicon layer (21) by epitaxy starting from the first silicon layer (20), before the simultaneous formation of the vibrating structure (22) and the electrodes (23).

7. Method according to claim 6, comprising the formation of a metal/oxide semiconductor transistor (26), at the same time as the vibrating structure (22) and the electrodes (23).

8. Method according to any one of claims 1 to 7, comprising the formation of variable capacitances (39, E1, E2) at the same time as the vibrating structure (22) and the electrodes (23).

## Patentansprüche

1. Herstellungsverfahren für ein elektromagnetisches Bauteil (10) auf einem ebenen Substrat (15), das wenigstens ein in der Ebene des Substrats (15) vibrierendes Element (22) und Betätigungselektroden (23) umfasst, wobei das Verfahren wenigstens die folgenden sukzessiven Schritte umfasst:
- Bildung des Substrats (15) mit wenigstens einer Siliciumzone (16) mit einer partiell von einer Isolationszone (18) bedeckten Oberseite (17),
- Bildung einer Opferschicht (19) aus Silicium-Germanium-Legierung durch selektive Epitaxie auf dem unbedeckten Teil der Oberseite (17) der Siliciumzone (16),
- Bildung einer Siliciumschicht (20) von vorherbestimmter Dicke (e2) durch Epitaxie, die wenigstens eine auf der genannten Opferschicht (19) vorgesehene monokristalline Zone (20b) und wenigstens eine auf der Isolationszone (18) vorgesehene polykristalline Zone (20a) umfasst,
- simultane Bildung des Vibrationselements (22) und der Betätigungselektroden (23) durch Ätzung eines vorherbestimmten Musters in die monokristalline Zone (20b), um Zwischenräumen (24) zu bilden zwischen den Elektroden (23) und dem Vibrationselement (22),
- Eliminierung der genannten Opferschicht (19) aus Silicium-Germanium-Legierung durch selektives Ätzen.

2. Verfahren nach Anspruch 1, wobei die Siliciumschicht (20) stark dotiert ist.

3. Verfahren nach einem der Ansprüche 1 und 2, wobei die Dicke des Vibrationselements (22) und der Elektroden (23) des elektromechanischen Bauteils (10) die Größenordung 100nm bis 600nm hat.

4. Verfahren nach einem der Ansprüche 1 bis 3 mit einem Schritt zur Herstellung einer Verkapselungsabdeckung (31) des Vibrationselements (22) des elektromechanischen Bauteils (10).

5. Verfahren nach Anspruch 4, wobei der genannte Schritt zur Herstellung der Verkapselungsabdeckung (31) - nach der simultanen Bildung des Vibrationselements (22) und der Elektroden (23) durch Ätzung - die folgenden Schritte umfasst:
- Bildung einer zweiten Opferschicht (30) aus Silicium-Germanium-Legierung durch Epitaxie und Ätzung,
- Bildung einer zur Herstellung der Verkapselungsabdeckung (31) dienenden Schicht aus monokristallinem Silicium durch Epitaxie,
- Ätzung einer Vielzahl von Öffnungen (32) in die Abdeckung (31),
- Elimination - durch selektives Ätzen durch die genannten Öffnungen (32) hindurch - der ersten (19) und der zweiten (30) Opferschicht aus Silicium-Germanium-Legierung,
- Bildung einer Schicht (33) aus Wiederabdichtungsmaterial auf der Abdeckung (31).

6. Verfahren nach einem der Ansprüche 1 bis 5, bei dem man - vor der simultanen Bildung des Vibrationselements (22) und der Elektroden (23) - durch Epitaxie auf der ersten Siliciumschicht (20) eine Zusatzschicht (21) aus undotiertem Silicium erzeugt.

7. Verfahren nach Anspruch 6, bei dem man - simultan zur Bildung des Vibrationselements (22) und der Elektroden (23) - einen Metall-Oxid-Nalbleiter-Transistor (26) bildet.

8. Verfahren nach einem der Ansprüche 1 bis 7, die Bildung variabler Kapazitäten (39, E1, E2) umfassend, simultan zu der Bildung des Vibrationselements (22) und der Elektroden (23).
